(19) Europäisches Patentamt
European Patent Office
Office européen des brevets

(11) **EP 4 538 769 A1**

(12) **EUROPEAN PATENT APPLICATION**
published in accordance with Art. 153(4) EPC

(43) Date of publication:
**16.04.2025 Bulletin 2025/16**

(21) Application number: 24829353.2

(22) Date of filing: **28.02.2024**

(51) International Patent Classification (IPC):
*G02B 27/00* (2006.01)    *F21S 41/25* (2018.01)
*F21S 41/32* (2018.01)    *F21S 43/20* (2018.01)
*F21S 43/31* (2018.01)    *F21W 107/10* (2018.01)

(86) International application number:
**PCT/CN2024/078878**

(87) International publication number:
**WO 2025/015925 (23.01.2025 Gazette 2025/04)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **18.07.2023 CN 202310880140**

(71) Applicant: **Changzhou Xingyu Automotive
Lighting
Systems Co., Ltd.
Changzhou, Jiangsu 213022 (CN)**

(72) Inventors:
• **ZHENG, Xianliang
  Changzhou, Jiangsu 213022 (CN)**
• **ZHOU, Xiaoping
  Changzhou, Jiangsu 213022 (CN)**
• **XU, Yuejia
  Changzhou, Jiangsu 213022 (CN)**

(74) Representative: **Behr, Wolfgang
Lorenz Seidler Gossel
Rechtsanwälte Patentanwälte
Partnerschaft mbB
Widenmayerstraße 23
80538 München (DE)**

(54) **OPTICAL SURFACE CONSTRUCTION METHOD BASED ON B-SPLINE**

(57)    The present disclosure relates to the field of automobiles, particularly to the field of automotive lighting equipment manufacturing, and specifically to a method for constructing an optical surface based on a B-spline. The method includes the following steps: refracting or reflecting, by an outgoing surface, incident light to a target light distribution surface, and determining a surface basis function and an initial control point based on coordinates of outgoing surface control points; calculating coordinates of outgoing surface key points based on u and v values in a B-spline curve definition equation and the coordinates of the outgoing surface control points; generating a surface key point parameter matrix based on the coordinates of the outgoing surface key points; and solving a coordinate of a surface control point by performing inversion on the surface key point parameter matrix, and forming the optical surface from the coordinate of the surface control point. The present disclosure has the following advantages. The present disclosure simplifies the calculation process of the optical free-form surface, and directly solves the control point of the free-form surface. The generated free-form surface is described by a B-spline function, which reduces the amount of process data, saves computer memory, improves computational efficiency, and significantly reduces computation time.

FIG. 1

EP 4 538 769 A1

**Description**

**TECHNICAL FIELD**

The present disclosure relates to the field of automobiles, particularly to the field of automotive lighting equipment manufacturing, and specifically to a method for constructing an optical surface based on a B-spline.

**BACKGROUND**

Automotive lighting is an important functional component of automobiles. In order to adapt to the vehicle model, expand the lighting range, and improve the viewing experience, there are many surfaces provided in the automotive lighting components.

Precise calculation of surface curvature is required during the design process. Chinese patent application CN109116555B provides a design method for a free-form surface lens for inclined surface illumination, which uses Monge-Ampère (MA) method to calculate the surface, and specifically includes the following steps. (1) An initial structure of a free-form surface is set. (2) A coordinate relation equation between a light source and a target point is established. (3) An energy transfer equation is established based on local energy conservation. (4) A boundary condition equation is established. (5) Discrete data points of the free-form surface are solved. (6) The discrete points are fitted to obtain a surface, and a solid is obtained from the surface.

The above surface solving method requires first solving the surface discrete data points of the optical surface and then fitting the discrete points to form the surface. This solving method cannot directly obtain the surface expression and requires a large number of discrete data points to accurately fit the surface, resulting in a large amount of computation and a slow solving process.

**SUMMARY**

A technical problem to be solved by the present disclosure is that the existing method involves a large amount of surface calculation, a cumbersome calculation process, and a slow calculation speed.

Therefore, the present disclosure provides a method for constructing an optical surface based on a B-spline.

The present disclosure solves the technical problem with the following technical solution:

A method for constructing an optical surface based on a B-spline includes the following steps:

step 1: refracting or reflecting, by an outgoing surface, incident light to a target light distribution surface, and determining a surface basis function and an initial control point based on coordinates of outgoing surface control points;

step 2: calculating coordinates of outgoing surface key points based on u and v values in a B-spline curve definition equation and the coordinates of the outgoing surface control points;

step 3: generating a surface key point parameter matrix based on the coordinates of the outgoing surface key points; and

step 4: solving a coordinate of a surface control point by performing inversion on the surface key point parameter matrix, and forming the optical surface from the coordinate of the surface control point.

**In** the above technical solution, a B-spline function is used to describe the surface, simplifying the calculation process of the optical free-form surface, skipping the coordinates of the surface point, and directly solving the control point of the free-form surface. The generated free-form surface is described by the B-spline function, which reduces the amount of process data, saves computer memory, improves computational efficiency, and significantly reduces computation time.

Furthermore, in the step 1, the incident light is parallel light; an energy distribution of outgoing light forms the target light distribution surface, and the target light distribution surface is regular; an incident surface formed by the incident light is parallel to the outgoing surface, with a spacing of d; and a plurality of incident surface control points arranged in a rectangular array on the incident surface and a plurality of outgoing surface control points arranged in a rectangular array on the outgoing surface are obtained by mutual translation.

Furthermore, in the step 1, the incident light is diffuse light; an energy distribution of outgoing light forms the target light distribution surface, and the target light distribution surface is regular; the outgoing surface includes a plurality of outgoing surface control points arranged in a rectangular array; x- and y-coordinates of the plurality of outgoing surface control points are known; coordinates of a source of the incident light are denoted as $(x_7, y_7, z_7)$; an initial surface of the outgoing surface is a conical surface; and according to a conical surface equation, z-coordinates of the plurality of outgoing surface control points are obtained through a least squares fitting method.

Furthermore, x- and y-coordinates of the outgoing surface key points are the same as the x and y-coordinates of the plurality of outgoing surface control points.

Furthermore, the incident light is refracted by the outgoing surface to a position of a target point; and in the step 2, a mapping relation between the outgoing surface and the target light distribution surface is established to determine a coordinate of the target point.

Furthermore, the outgoing surface control points are uniformly distributed within the outgoing surface.

Furthermore, the outgoing surface key points are uniformly distributed within a UV plane, and a number of the outgoing surface key points is adapted to a number of the outgoing surface control points.

Furthermore, in the step 3, the surface key point parameter matrix is obtained based on a center coordinate of an incident surface and a center coordinate of the outgoing surface.

Furthermore, incident vectors $\{n_{in,i,j}\}$ of light at the outgoing surface key points are calculated based on a direction vector of the incident light, an expression of an incident surface, a refractive index of a medium between the incident surface and the outgoing surface, and coordinates $\{P_{42,i,j}\}$ of the outgoing surface key points, combined with Fermat's principle; outgoing vectors $\{n_{out,i,j} = P_{62,i,j} - P_{42,i,j}\}$ of the light at the outgoing surface key points are calculated based on the coordinates $\{P_{42,i,j}\}$ of the outgoing surface key points and coordinates $\{P_{62,i,j} = (x_{42,i,j}, Y_{42,i,j}, z_{42,i,j})\}$ of an outgoing surface target point; and normal vectors of the outgoing surface key points are calculated based on the incident vectors of the outgoing surface key points, the outgoing vectors of the outgoing surface key points, and the refractive index of the medium, combined with a law of refraction.

Furthermore, based on a center z-coordinate $N(1/2, 1/2) \cdot Z_{21}^{T}$ of the incident surface and a center z-coordinate $N(1/2, 1/2) \cdot Z_{411}^{T}$ of the outgoing surface, a coordinate matrix $Z_{21}^{T}$ of the outgoing surface control points is calculated according to $N(1/2, 1/2) \cdot Z_{411}^{T} = N(1/2, 1/2) \cdot Z_{21}^{T} + d$.

The present disclosure has the following advantages. The present disclosure uses a B-spline function to describe the surface, simplifying the calculation process of the optical free-form surface, skipping the coordinates of the surface point, and directly solving the control point of the free-form surface. The generated free-form surface is described by the B-spline function, which reduces the amount of process data, saves computer memory, improves computational efficiency, and significantly reduces computation time. The present disclosure uses a normal vector instead of a surface tangent vector, reducing the surface characteristic function from a quadratic function to a linear function, thereby simplifying the parameter matrix and reducing computational complexity. The free-form surface generated has a universal format and simplified data, and can be directly used for subsequent data stitching, cutting, and other processing.

**BRIEF DESCRIPTION OF THE DRAWINGS**

The present disclosure will be further described below in conjunction with the drawings and embodiments.

FIG. 1 is a flowchart of an algorithm according to the present disclosure;
FIG. 2 is a diagram of an incident light path according to Embodiment 1 of the present disclosure;
FIG. 3 is a schematic diagram of control points of an initialized outgoing surface according to Embodiment 1 of the present disclosure;
FIG. 4 is a schematic diagram of a mapping relation between an outgoing surface and a target light distribution surface according to Embodiment 1 of the present disclosure;
FIG. 5 is a schematic diagram of surface shapes and control points of the outgoing surface before and after solving according to Embodiment 1 of the present disclosure;
FIG. 6 is a distribution comparison diagram of a light shape corresponding to the surface shape of the outgoing surface before solving and a light shape corresponding to the surface shape of the outgoing surface after solving according to Embodiment 1 of the present disclosure;
FIG. 7 is a schematic diagram of an incident light path according to Embodiment 2 of the present disclosure;
FIG. 8 is a schematic diagram of control points of an initialized outgoing surface according to Embodiment 2 of the present disclosure;
FIG. 9 is a schematic diagram of a mapping relation between an outgoing surface and a target light distribution surface according to Embodiment 2 of the present disclosure;
FIG. 10 is a schematic diagram of surface shapes and control points of the outgoing surface before and after solving according to Embodiment 2 of the present disclosure; and
FIG. 11 is a distribution comparison diagram of a light shape corresponding to the surface shape of the outgoing surface before solving and a light shape corresponding to the surface shape of the outgoing surface after solving according to Embodiment 2 of the present disclosure.

Reference Numerals: 1. incident light; 2. incident surface; 21. incident surface control point; 3. refractive medium; 4. outgoing surface; 41. outgoing surface control point; 42. outgoing surface key point; 5. outgoing light; 6. target light distribution surface; 62. target point; 400. surface shape of outgoing surface before solving; 401. surface shape of outgoing surface after solving; 410. outgoing surface control point before solving; 411. outgoing surface control point after solving; and 7. point light source.

## DETAILED DESCRIPTION OF THE EMBODIMENTS

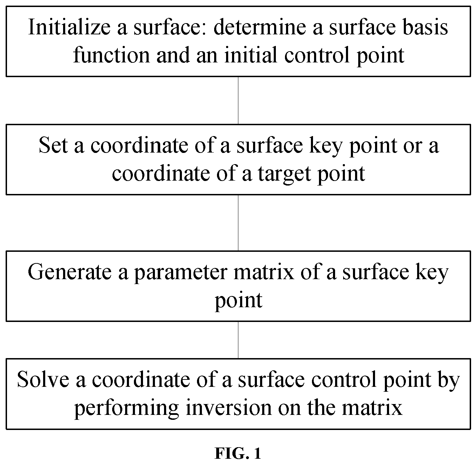

The present disclosure is described in further detail below according to FIGS. 1 to 6. These drawings are all simplified schematic diagrams, which merely illustrate the basic structure of the present disclosure in a schematic manner, and thus only show the parts associated with the present disclosure.

In the description of the present disclosure, it should be understood that orientation or position relationships indicated by terms such as "center", "thickness", "upper", "lower", "front", and "back" are described based on the drawings, and these terms are just used to facilitate description of the present disclosure and simplify the description, rather than to indicate or imply that the mentioned apparatus or elements must have a specific orientation or must be established and operated in a specific orientation. Therefore, these terms cannot be understood as a limitation to the present disclosure. In addition, features defined with "first" and "second" may explicitly or implicitly include one or more of the features. In the description of the present disclosure, unless otherwise specified, "a plurality of" means two or more. Those of ordinary skill in the art may understand specific meanings of the foregoing terms in the present disclosure based on specific situations.

As shown in FIG. 1, a method for constructing an optical surface based on a B-spline includes the following steps.

A surface is initialized, and incident light is refracted or reflected by an outgoing surface to a target light distribution surface. In this step, based on the incident light, the outgoing surface is solved through a refractive surface to obtain a surface basis function and an initial control point. Alternatively, an incident surface is solved through the outgoing surface to obtain the surface basis function and the initial control point.

Coordinates of a surface key point and a target point are set.

A parameter matrix is generated for the surface key point.

Coordinates of a surface control point are solved.

B-spline function is a surface description standard in the field of computer-aided design (CAD). A p-order B-spline curve applied in this embodiment is defined as follows:

$$C(u) = \sum_{i=0}^{n} N_{i,p}(u) P_i$$

where, $\{P_i = [x_i, y_i, z_i]\}$ denotes a control point; and $\{N_{i,p}(u)\}$ denotes a p-order B-spline basis function, which is obtained through a knot vector U and the following recursion equation:

$$N_{i,p}(u) = \frac{u - u_i}{u_{i+p} - u_i} N_{i,p-1}(u) + \frac{u_{i+p+1} - u}{u_{i+p+1} - u_{i+1}} N_{i+1,p-1}(u)$$

The independent variable u is an implicit expression parameter with a value range of [0,1]. The coordinate C(u) of any point on the curve is a mapping of u. This algorithm can be extended to two-dimensional. A B-spline surface with two directions of p-order and q-order is defined by a control point mesh as follows:

$$S(u, v) = \sum_{i=0}^{n} \sum_{j=0}^{m} N_{i,p}(u) N_{j,q}(v) P_{i,j}$$

where, $\{P_{i,j} = [x_{i,j}, y_{i,j}, z_{i,j}]\}$ denotes a control point; $\{N_{i,p}(u)\}$ denotes a p-order B-spline basis function; $\{N_{j,q}(v)\}$ denotes a q-order B-spline basis function; the independent variables u and v are implicit expression parameters; and the coordinates S(u,v) of any point on the surface are a mapping of u and v.

In the present disclosure, the B-spline has the following characteristics.

(1) When u and v are definite, the basis function is a real number, and the surface point coordinates $S$(u,v) are a linear superposition of the control point $P_{i,j}$, which can also be written in matrix form:

$$S(u, v) = N(u, v) \cdot P^T \quad (1)$$

where, N denotes a matrix of basis function coefficients, with 1 row and m×n columns, written as:

$$N = [N_{0,p}(u)N_{0,q}(v) \quad ... \quad N_{n,p}(u)N_{0,q}(v) \quad N_{0,p}(u)N_{1,q}(v) \quad ... \quad N_{n,p}(u)N_{m,q}(v)]$$

where, $P^T$ denotes transpose of a control point matrix $P$; and $P$ includes 1 rows and m×n column, and is written as:

$$P = [P_{0,0} \quad ... \quad P_{n,0} \quad P_{0,1} \quad ... \quad P_{n,m}]$$

(2) When u and v are definite, a first-order partial differential $\dfrac{dN_{i,p}(u)}{du}$ of the p-order basis function with respect to u can be obtained from a (p-1)-order basis function, and a first-order partial differential $\dfrac{dN_{j,q}(v)}{dv}$ of the q-order basis function with respect to v can be obtained from a (q-1)-order basis function

$$\frac{dN_{i,p}(u)}{du} = N'_{i,p} = \frac{p}{u_{i+p}-u_i}N_{i,p-1}(u) + \frac{p}{u_{i+p+1}-u_{i+1}}N_{i+1,p-1}(u)$$

$$\frac{dN_{j,q}(v)}{dv} = N'_{j,q} = \frac{q}{u_{j+q}-u_j}N_{j,q-1}(v) + \frac{q}{u_{j+q+1}-u_{j+1}}N_{j+1,q-1}(v)$$

Tangent vectors of the surface in the u and v directions are also a linear superposition of the control point $P_{i,j}$, which are written in matrix form:

$$S'_u = [x'_u, y'_u, z'_u] = \frac{\partial S(u,v)}{\partial u} = N'_u(u, v) \cdot P^T \quad (2)$$

$$S'_v = [x'_v, y'_v, z'_v] = \frac{\partial S(u,v)}{\partial v} = N'_v(u, v) \cdot P^T \quad (3)$$

(3) If a normal vector of the B-spline surface at (u, v) is n(u, v) = [$x_n$, $y_n$, $z_n$], then since the normal vector is perpendicular to the tangent vector, it can be inferred that:

$$n(u, v) \cdot S'_u = 0$$

$$|n(u, v) \cdot S'_v = 0$$

Substituting Eqs. 2 and 3 yields:

$$x_n x'_u + y_n y'_u + z_n N'_u(u, v) \cdot Z^T = 0 \quad (4)$$

$$x_n x'_v + y_n y'_v + z_n N'_v(u,v) \cdot Z^T = 0 \quad (5)$$

As mentioned earlier, the B-spline surface is determined by the order p, the order q, the knot vector U, the knot vector V, and the control point $\{P_{i,j}\}$. The coefficients outside the control point $\{P_{i,j}\}$ can be determined during the initialization of the surface. In general, the x- and y-coordinates of the control point $\{P_{i,j}\}$, namely $\{x_{i,j}\}$ and $\{y_{i,j}\}$, can also be determined during initialization. Therefore, solving the B-spline optical surface is to solve the z-coordinate $Z = \{z_{i,j}\}$ of the control point z. According to Eqs. 1, 2, and 3, it can be seen that the z-coordinate of the point P(u,v) on the B-spline surface and the z-component of the tangent vector are both linear functions with respect to $P^T$. When the UV coordinates of P(u,v) are definite, equation 1 is a linear function with respect to $Z^T$. When the normal vector n(u, v) is definite, Eqs. 4 and 5 are linear functions with respect to $Z^T$.

Embodiment 1

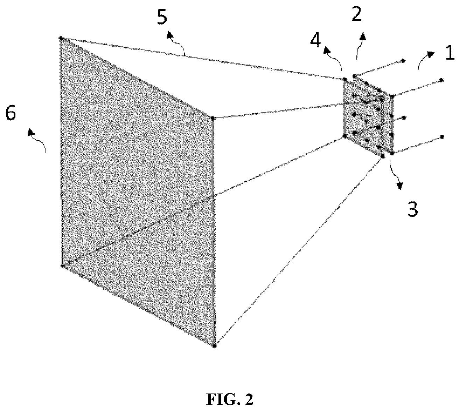

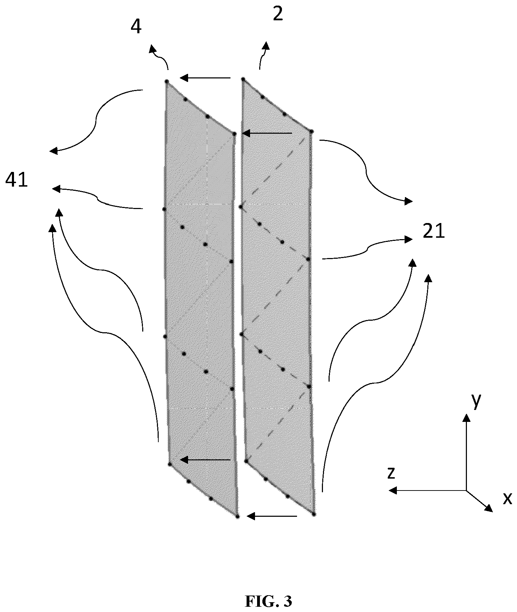

Referring to FIGS. 2 to 6, according to the above equations, in this embodiment, the refractive surface and the outgoing surface are solved based on the incident light, thereby solving the B-spline optical surface.
As shown in FIG. 2, when incident light 1 is given parallel light parallel to a z-axis, an energy distribution of an outgoing light 5 forms a target light distribution surface 6 (e.g. square distribution), a refractive index of a medium 3 between an incident surface 2 and an outgoing surface 4 is $n_{med}$, and the incident surface 2 is a given B-spline surface. Thus, the steps for solving the outgoing surface 4 are as follows.
Step 1. A surface is initialized to determine a surface basis function and an initial control point.
As shown in FIGS. 2 and 3, a (3 to 5)-order B-spline is used to describe a surface with a smooth surface shape free from excessive distortion. If plane where the outgoing surface 4 is located serves as an XY plane and the incident surface 2 is a B-spline surface with all directions being 3-order, then the incident surface 2 has 4×4=16 control points. If incident surface control points 21 of the incident surface 2 are uniformly distributed in the XY plane and an initial z-distance between the incident surface 2 and the outgoing surface 4 is 2 mm, then as shown in FIG. 3, the initialized outgoing surface 4 also has 16 outgoing surface control points 41 uniformly distributed in the XY plane. The XY coordinates of the outgoing surface control point 41 are the same as those of the incident surface control point 21. The initial z-coordinate of the outgoing surface control point 41 is the z-coordinate of the incident surface control point 21 plus 2 mm. Therefore, the initial control point of the outgoing surface 4 is obtained as follows:

$$x_{410,i,j} = x_{21,i,j}$$

$$y_{410,i,j} = y_{21,i,j}$$

$$z_{410,i,j} = z_{21,i,j} + 2mm$$

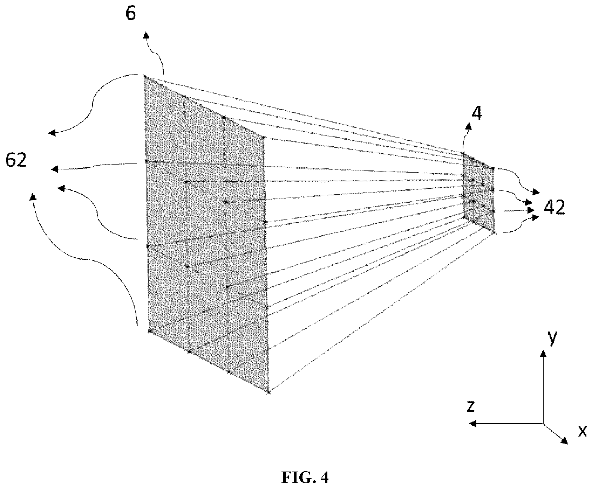

Step 2. Coordinates of a surface key point and a target point are set.
As shown in FIGS. 3 and 4, in this step, the outgoing surface key point 42 is a point located on a surface of the outgoing surface 4, which is determined by UV values and coordinates of the outgoing surface control point 41. The outgoing surface key point 42 serves two purposes: the local position of the outgoing surface 4 is controlled by adjusting the z-coordinate of the outgoing surface key point 42, and the local light outgoing direction of the outgoing surface 4 is controlled by adjusting a normal vector of the outgoing surface 4 at the outgoing surface key point 42. One way to set the outgoing surface key points 42 is to make them evenly distributed in the UV plane and equal in number to the control points. For example, if the u and v values of the outgoing surface key points 42 both are {0,1/3,2/3,1}, then there are a total of 4×4=16 key points. Due to the uniform distribution of the control points in the XY plane, the x-coordinate and y-coordinate of the outgoing surface key point 42 are the same as the corresponding outgoing surface control point 41, that is:

$$x_{42,i,j} = x_{21,i,j}$$

$$y_{42,i,j} = y_{21,i,j}$$

The incident light 1 completes a reflection at the key point 42 on the surface of the outgoing surface 4 before it reaches the target point 62. In order to ensure that the energy distribution of the outgoing light 5 conforms to the target light distribution surface 6, as shown in FIG. 4, a mapping relation between the outgoing surface 4 and the target light distribution surface 6 is established. The mapping relation is not unique, and the present disclosure provides one of them, following the principle of edge to edge and center to center. Since the outgoing surface key points 42 are uniformly distributed on the outgoing surface 4, the target points 62 are also uniformly distributed on the target light distribution surface 6. The rectangular target light distribution surface 6 is uniformly divided into 3×3=9 grids, with a total of 4×4=16 vertices, serving as the target points 62. Thus, the coordinates $\{(x_{6,i,j}, y_{6,i,j}, z_{6,i,j})\}$ of the target point 62 can be determined.

Step 3. A surface key point parameter matrix is established.

As shown in FIGS. 3 and 4, the final coordinates of the outgoing surface control point 41 are denoted as $\{(x_{411,i,j}, y_{412,i,j}, z_{411,i,j})\}$:

$$x_{411,i,j} = x_{410,i,j}$$

$$y_{411,i,j} = y_{410,i,j}$$

Since $Z_{411} = [z_{411,i,j}]$, the z-direction position and surface normal vector of the outgoing surface 4 can be controlled. In this embodiment, the direction vector of the incident light 1 is (0,0,1). After completing a first refraction on the incident surface 2, the incident light 1 reaches the outgoing surface key point 42 and completes a second refraction at the outgoing surface key point 42. Based on the direction vector of the incident light 1, the expression of the incident surface 2, the refractive index $n_{med}$ of the medium 3, and the coordinates $\{P_{42,i,j} = (x_{42,i,j}, y_{42,i,j}, z_{42,i,j})\}$ of the outgoing surface key point 42, combined with Fermat's principle, the incident vector $\{n_{in,i,j}\}$ of the light at the outgoing surface key point 42 is obtained. Based on the coordinate $\{P_{42,i,j}\}$ of the outgoing surface key point 42 and the coordinates $\{P_{62,i,j} = (x_{6,i,j}, y_{6,i,j}, z_{6,i,j})\}$ of the target point 62, the outgoing vector $\{n_{out,i,j} = P_{62,i,j} - P_{42,i,j}\}$ of the light at the outgoing surface key point 42 is obtained. Based on the incident vector $\{n_{in,i,j}\}$, the outgoing vector $\{n_{out,i,j}\}$, and the refractive index $n_{med}$ of the medium 3, combined with a law of refraction, the normal vector $\{n_{42,i,j} = (x_{n42,i,j}, y_{n42,i,j}, z_{n42,i,j})\}$ of the outgoing surface 4 at the outgoing surface key point 42 is obtained. Substituting the normal vector into Eq. (4) yields:

$$x_{n42,i,j}x'_{u,i,j} + y_{n42,i,j}y'_{u,i,j} + z_{n42,i,j}N'_{u,i,j} \cdot Z^T_{411} = 0$$

where, $x_{n42,i,j}$, $x'_{u,i,j}$, $y_{n42,i,j}$, $y'_{u,i,j}$ and $z_{n42,i,j}$ are all given values; $N'_{u,i,j}$ is a given matrix; and $Z^T_{41}$ is a z-coordinate matrix of the control point of the outgoing surface 4 to be solved. The above equation is transformed to obtain 16 linear equations of $Z^T_{411}$:

$$|z_{n42,i,j}N'_{u,i,j} \cdot Z^T_{411} = -x_{n42,i,j}x'_{u,i,j} - y_{n42,i,j}y'_{u,i,j} \quad i,j \in \{0,1,2,3\} \quad (6)$$

Similarly, 16 linear equations of $Z^T_{411}$ are obtained from Eq. (5):

$$z_{n42,i,j}N'_{v,i,j} \cdot Z^T_{411} = -x_{n42,i,j}x'_{v,i,j} - y_{n42,i,j}y'_{v,i,j} \quad i,j \in \{0,1,2,3\} \quad (7)$$

Eqs. (6) and (7) constrain the surface normal vector of the outgoing surface 4, but do not constrain the z-direction position of the outgoing surface 4. Due to the uniform distribution of the incident surface control points 21 on the incident surface 2, in the UV function, the values of u and v range from 0 to 1, so the values of u and v are 1/2. According to Eq. (1), the center z-coordinate of the incident surface 2 is a constant $N(1/2,1/2) \cdot Z^T_{21}$. Similarly, the center z-coordinate of the outgoing surface 4 is $N(1/2,1/2) \cdot Z^T_{411}$. Thus, the following equation is obtained, which constrains the center thickness of the outgoing surface 4 to 2 mm:

$$N(1/2,1/2) \cdot Z_{411}^T = N(1/2,1/2) \cdot Z_{21}^T + 2mm \quad (8)$$

The above Eqs. (6) to (8) are all linear equations of $Z_{411}^T$, with constants on the right-hand side of the equations, and can be constructed in the following form:

$$A \cdot Z_{411}^T = B \quad (9)$$

Matrices A and B are key point parameter matrices, where the matrix A is a constant matrix with 33 rows and 16 columns, and is constructed as follows:

$$A = \begin{bmatrix} z_{n42,0,0} N'_{u,0,0} \\ \vdots \\ z_{n42,3,0} N'_{u,3,0} \\ z_{n42,0,1} N'_{u,0,1} \\ \vdots \\ z_{n42,3,3} N'_{u,3,3} \\ z_{n42,0,0} N'_{v,0,0} \\ \vdots \\ z_{n42,3,0} N'_{v,3,0} \\ z_{n42,0,1} N'_{v,0,1} \\ \vdots \\ z_{n42,3,3} N'_{v,3,3} \\ N(1/2,1/2) \end{bmatrix}$$

The matrix B is a constant matrix with 33 rows and 1 column, and is constructed as follows:

$$B = \begin{bmatrix} -x_{n42,0,0} x'_{u,0,0} - y_{n42,0,0} y'_{u,0,0} \\ \vdots \\ -x_{n42,3,0} x'_{u,3,0} - y_{n42,3,0} y'_{u,3,0} \\ -x_{n42,0,1} x'_{u,0,1} - y_{n42,0,1} y'_{u,0,1} \\ \vdots \\ -x_{n42,3,3} x'_{u,3,3} - y_{n42,3,3} y'_{u,0,0} \\ -x_{n42,0,0} x'_{u,0,0} - y_{n42,0,0} y'_{u,0,0} \\ \vdots \\ -x_{n42,3,0} x'_{u,3,0} - y_{n42,3,0} y'_{u,3,0} \\ -x_{n42,0,1} x'_{u,0,1} - y_{n42,0,1} y'_{u,0,1} \\ \vdots \\ -x_{n42,3,3} x'_{u,3,3} - y_{n42,3,3} y'_{u,0,0} \\ N(1/2,1/2) \cdot Z_{21}^T + 2 \end{bmatrix}$$

Step 4. The coordinates of the surface control point are solved through a matrix inversion operation.

An inverse matrix of the matrix $A$ is denoted as $A^{-1}$, $A^{-1}AZ_{41}^T = Z_{411}^T$, then the z-coordinate of the outgoing surface control point 4 can be solved from Eq. (9):

$$|Z_{411}^T = A^{-1} \cdot B$$

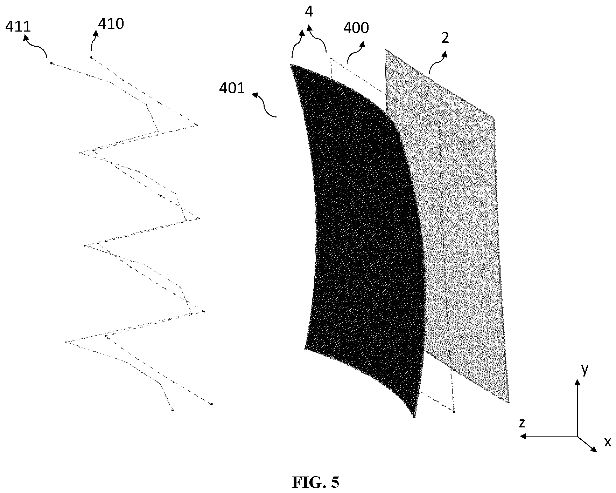

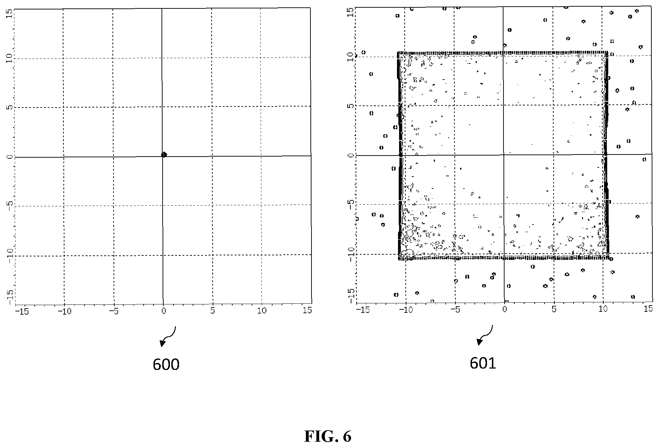

The surface shape and control point of the outgoing surface 4 before and after solving are shown in FIG. 5. It can be seen that the surface shape 400 of the outgoing surface 4 before solving is a translation surface of the incident surface 2, which has a same flat surface as the incident surface 2. The surface shape 401 of the outgoing surface 4 after solving is a concave surface with a concave center and a convex periphery. The surface shape 401 of the outgoing surface 4 after solving corresponds to the outgoing surface control point 411 of the outgoing surface 4 after solving, which is significantly different from the outgoing surface control point 410 of the outgoing surface 4 before solving corresponding to the surface shape 400 of the outgoing surface 4 before solving. A simulation comparison result is shown in FIG. 6.

Embodiment 2

This embodiment is different from Embodiment 1 in that, in the step 1, the outgoing surface 4 is known, and the surface basis function and initial control point are obtained by solving the incident light 1 and the incident surface 2 through the outgoing surface 4.

Given that the coordinates of the outgoing surface control point 41 are $\{(x_{410,i,j}, y_{410,i,j}, z_{410,i,j})\}$, the outgoing surface control points 41 are uniformly distributed in the XY plane, and the incident surface control point 21 is $\{(x_{21,i,j}, y_{21,i,j}, z_{21,i,j})\}$, where:

$$x_{21,i,j} = x_{410,i,j}$$

$$y_{21,i,j} = y_{410,i,j}$$

$$|z_{21,i,j} = z_{410,i,j} - 2mm$$

Embodiment 3

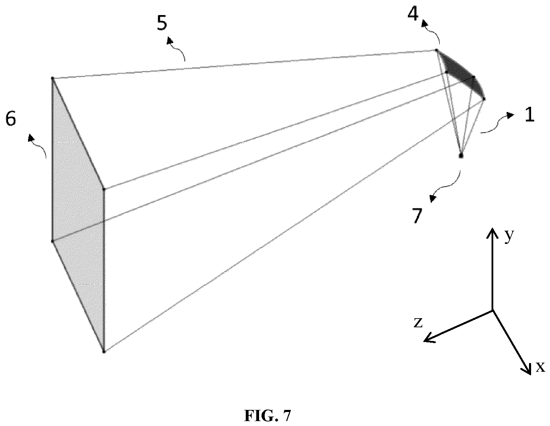

Referring to FIGS. 7 to 11, a difference between this embodiment and Embodiment 1 is that this embodiment solves the optical B-spline surface by solving the reflective surface of the light source and the outgoing surface after reflection.

As shown in FIG. 7, the difference from Embodiment 1 is that in this embodiment, the incident light 1 is a point light source 7. The light emitted by the point light source 7 is diffuse. When the point light source 7 is diffuse and the energy distribution of the outgoing light 5 forms a given light distribution 6 (square distribution shown in FIG. 7), the steps for solving the outgoing surface 4 are as follows.

Step 1. A surface is initialized to determine a surface basis function and an initial control point.

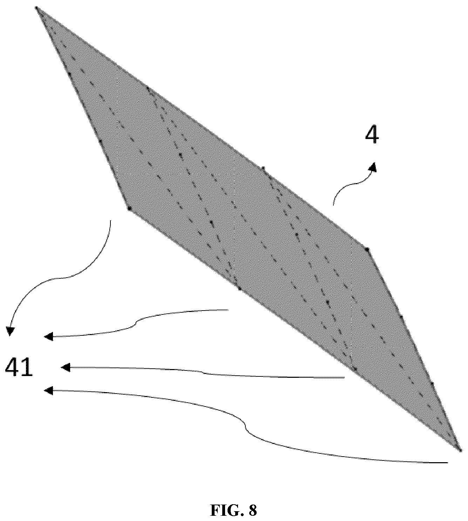

A (3-5)-order B-spline is used to accurately and efficiently describe a surface with a smooth surface shape free from excessive distortion. Assuming that the outgoing surface 4 is a B-spline surface with UV directions being 3-order, there are 4×4=16 control points on the outgoing surface 4. As shown in FIG. 8, assuming that the outgoing surface 4 includes 16 uniformly distributed control points 41: $\{(x_{410,i,j}, y_{410,i,j}, z_{410,i,j})\}$ in the XY plane, the x-coordinate and y-coordinate of the outgoing surface control points 41 are given values. If the coordinates of the point light source 7 are $(x_7, y_7, z_7)$ and the initial surface of the outgoing surface 4 is a conical surface, then depending on the required distance of the light source to a target projected through the reflection of the outgoing surface 4, the outgoing surface 4 can be a parabolic, ellipsoidal, or hyperbolic surface. The projection distance of the light source after reflection of a parabolic surface is relatively large, while the projection distance of the light source after reflection of an ellipsoidal surface is relatively small. In this embodiment, the outgoing surface 4 is a parabolic surface with a focal length of f mm. According to a parabolic equation:

$$z = ((x - x_7)^2 + (y - y_7)^2)/4f + z_7 - f$$

The z-coordinate of the outgoing surface control point 41 is obtained using a least squares fitting method.

Step 2. Coordinates of a surface key point and a target point are set.

In this embodiment, the method of setting the outgoing surface key point 42 and the target point 62 is the same as that in Embodiment 1, and will not be repeated here. There are a total of 16 key points, with the coordinate being $\{P_{42,i,j}\} = \{(x_{42,i,j}, y_{42,i,j}, z_{42,i,j})\}$, satisfying:

$$x_{42,i,j} = x_{410,i,j}$$

$$y_{42,i,j} = y_{410,i,j}$$

$$z_{42,i,j} = \left(\left(x_{42,i,j} - x_7\right)^2 + \left(y_{42,i,j} - y_7\right)^2\right)/4f + z_7 - f$$

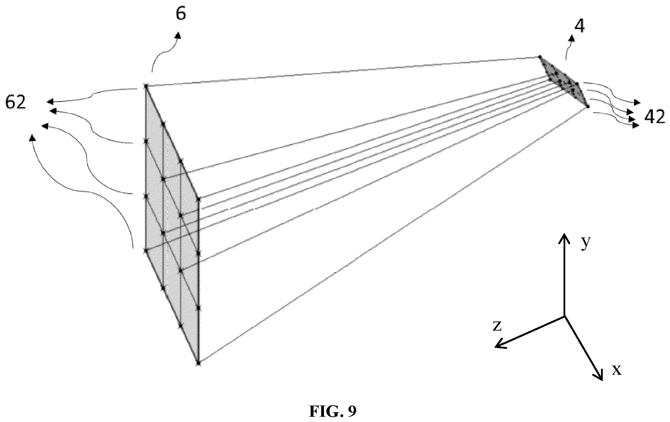

The mapping relation between the outgoing surface 4 and the light distribution 6 is shown in FIG. 9, and the coordinates of the target point 62 are $\{(x_{6,i,j}, y_{6,i,j}, z_{6,i,j})\}$.

Step 3. A surface key point parameter matrix is established.

The final coordinates of the outgoing surface control point 41 are $\{(x_{411,i,j}, y_{411,i,j}, z_{411,i,j})\}$:

$$x_{411,i,j} = x_{410,i,j}$$

$$y_{411,i,j} = y_{410,i,j}$$

Since $Z_{411} = [z_{411,i,j}]$, the z-direction position and surface normal vector of the outgoing surface 4 can be controlled. In this embodiment, the incident light 1 starts from the point light source 7, and the incident light 1 completes a reflection at the outgoing surface key point 42 before reaching the target point 62. Based on the coordinates $(x_7, y_7, z_7)$ of the point light source 7 and an initial value $\{P_{42,i,j}\}$ of the outgoing surface key point 42, the incident vector $\{n_{in,i,j}\}$ of the light at the outgoing surface key point 42 is obtained. Based on the coordinate $\{P_{42,i,j}\}$ of the outgoing surface key point 42 and the coordinates $\{P_{62,i,j} = (x_{6,i,j}, y_{6,i,j}, z_{6,i,j})\}$ of the target point 62, the outgoing vector $\{n_{out,i,j} = P_{62,i,j} - P_{42,i,j}\}$ of the light at the outgoing surface key point 42 is obtained. Based on the incident vector $\{n_{in,i,j}\}$ and the outgoing vector $\{n_{out,i,j}\}$, combined with the law of refraction, the normal vector $\{n_{42,i,j} = (x_n 42_{,i,j}, y_{n42,i,j}, z_{n42,i,j})\}$ of the outgoing surface key point 42 is obtained. The subsequent section is the same as that in Embodiment 1, and will not be repeated here.

Step 4. The coordinates of the surface control point are solved through a matrix inversion operation.

An inverse matrix of the matrix $A$ is denoted as $A^{-1}$, $A^{-1}AZ_{41}^T = Z_{411}^T$, then the z-coordinate of the outgoing surface control point 41 can be solved from Eq. (9):

$$Z_{411}^T = A^{-1} \cdot B$$

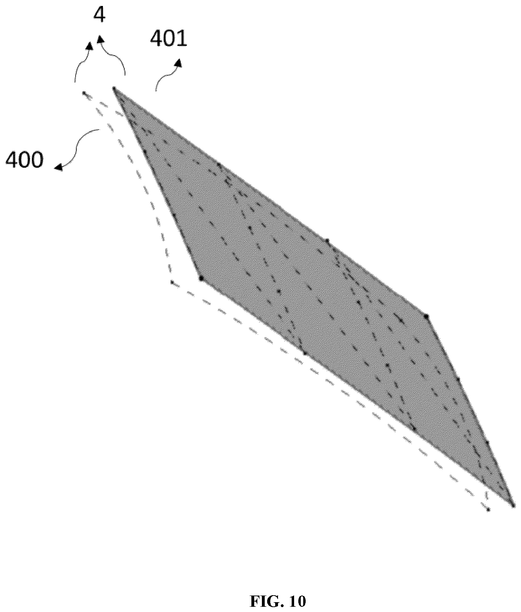

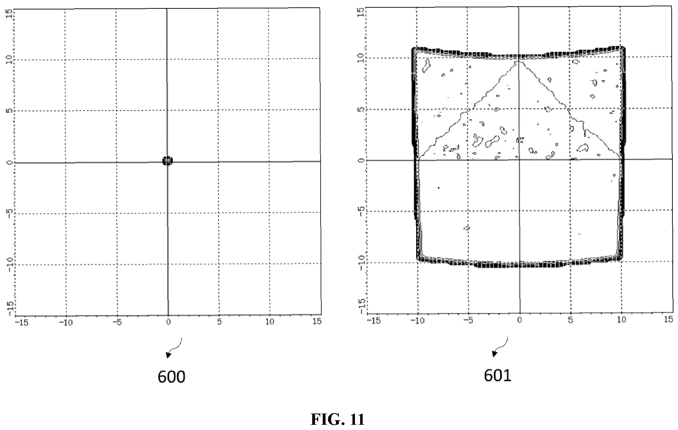

The surface shapes of the outgoing surface 4 before and after solving are shown in FIG. 10, and the simulation comparison result is shown in FIG. 11.

The present disclosure simplifies the calculation process of the optical free-form surface, skips the coordinates of the surface point, and directly solves the control point of the free-form surface. The generated free-form surface is described by the B-spline function, reach which reduces the amount of process data, saves computer memory, improves computational efficiency, and significantly reduces computation time. The calculation method uses a normal vector instead of a surface tangent vector, reducing the surface characteristic function from a quadratic function to a linear function, thereby simplifying the parameter matrix and reducing computational complexity. The free-form surface generated during the calculation process has a universal format and simplified data, and can be directly used for subsequent data stitching, cutting, and other processing.

Under the inspiration of the above ideal embodiments of the present disclosure, a skilled person can absolutely make various changes and modifications through the above description content without departing from the scope of the technical idea of the present disclosure. The technical scope of the present disclosure is not limited to the content of this specification, which must be determined according to the scope of the claims.

## Claims

1. A method for constructing an optical surface based on a B-spline, **characterized by** comprising the following steps:

   step 1: refracting or reflecting, by an outgoing surface (4), incident light (1) to a target light distribution surface (6), and determining a surface basis function and an initial control point based on coordinates of outgoing surface control points (41);

step 2: calculating coordinates of outgoing surface key points (42) based on u and v values in a B-spline curve definition equation and the coordinates of the outgoing surface control points (41);

step 3: generating a surface key point parameter matrix based on the coordinates of the outgoing surface key points (42); and

step 4: solving a coordinate of a surface control point by performing inversion on the surface key point parameter matrix, and forming the optical surface from the coordinate of the surface control point.

2. The method for constructing the optical surface based on the B-spline according to claim 1, **characterized in that** in the step 1, the incident light (1) is parallel light; an energy distribution of outgoing light (5) forms the target light distribution surface (6), and the target light distribution surface (6) is regular; an incident surface (2) formed by the incident light (1) is parallel to the outgoing surface (4), with a spacing of d; and a plurality of incident surface control points (21) arranged in a rectangular array on the incident surface (2) and a plurality of outgoing surface control points (41) arranged in a rectangular array on the outgoing surface (4) are obtained by mutual translation.

3. The method for constructing the optical surface based on the B-spline according to claim 1, **characterized in that** in the step 1, the incident light (1) is diffuse light; an energy distribution of outgoing light (5) forms the target light distribution surface (6), and the target light distribution surface (6) is regular; the outgoing surface (4) comprises a plurality of outgoing surface control points (41) arranged in a rectangular array; x- and y-coordinates of the plurality of outgoing surface control points (41) are known; coordinates of a source of the incident light (1) are denoted as $(x_7, y_7, z_7)$; an initial surface of the outgoing surface (4) is a conical surface; and according to a conical surface equation, z-coordinates of the plurality of outgoing surface control points (41) are obtained through a least squares fitting method.

4. The method for constructing the optical surface based on the B-spline according to claim 2 or 3, **characterized in that** x- and y-coordinates of the outgoing surface key points (42) are the same as the x- and y-coordinates of the plurality of outgoing surface control points (41).

5. The method for constructing the optical surface based on the B-spline according to claim 3, **characterized in that** the incident light (1) is refracted by the outgoing surface (4) to a position of a target point (62); and in the step 2, a mapping relation between the outgoing surface (4) and the target light distribution surface (6) is established to determine a coordinate of the target point (62).

6. The method for constructing the optical surface based on the B-spline according to any one of claims 1 to 5, **characterized in that** the outgoing surface control points (41) are uniformly distributed within the outgoing surface (4).

7. The method for constructing the optical surface based on the B-spline according to claim 6, **characterized in that** the outgoing surface key points (42) are uniformly distributed within a UV plane, and a number of the outgoing surface key points (42) is adapted to a number of the outgoing surface control points (41).

8. The method for constructing the optical surface based on the B-spline according to claim 1, **characterized in that** in the step 3, the surface key point parameter matrix is obtained based on a center coordinate of an incident surface (2) and a center coordinate of the outgoing surface (4).

9. The method for constructing the optical surface based on the B-spline according to claim 1, **characterized in that** incident vectors $\{n_{in,i,j}\}$ of light at the outgoing surface key points (42) are calculated based on a direction vector of the incident light (1), an expression of an incident surface (2), a refractive index of a medium between the incident surface (2) and the outgoing surface (4), and coordinates $\{P_{42,i,j}\}$ of the outgoing surface key points (42), combined with Fermat's principle; outgoing vectors $\{n_{out,i,j} = P_{62,i,j} - P_{42,i,j}\}$ of the light at the outgoing surface key points (42) are calculated based on the coordinates $\{P_{42,i,j}\}$ of the outgoing surface key points (42) and coordinates $\{P_{62,i,j} = (x_{42,i,j}, Y_{42,i,j}, z_{42,i,j})\}$ of an outgoing surface target point; and normal vectors of the outgoing surface key points (42) are calculated based on the incident vectors of the outgoing surface key points (42), the outgoing vectors of the outgoing surface key points (42), and the refractive index of the medium, combined with a law of refraction.

10. The method for constructing the optical surface based on the B-spline according to claim 2, **characterized in that** based on a center z-coordinate $N(1/2, 1/2) \cdot Z_{21}^{T}$ of the incident surface (2) and a center z-coordinate

$N(1/2,1/2) \cdot Z_{411}^{T}$ of the outgoing surface (4), a coordinate matrix $Z_{21}^{T}$ of the outgoing surface control points (41) is calculated according to $N(1/2,1/2) \cdot Z_{411}^{T} = N(1/2,1/2) \cdot Z_{21}^{T} + d$.

Initialize a surface: determine a surface basis function and an initial control point

Set a coordinate of a surface key point or a coordinate of a target point

Generate a parameter matrix of a surface key point

Solve a coordinate of a surface control point by performing inversion on the matrix

FIG. 1

**FIG. 2**

**FIG. 3**

**FIG. 4**

**FIG. 5**

600

601

**FIG. 6**

**FIG. 7**

**FIG. 8**

**FIG. 9**

**FIG. 10**

600

601

**FIG. 11**

## INTERNATIONAL SEARCH REPORT

| International application No. |
| --- |
| **PCT/CN2024/078878** |

| A. | CLASSIFICATION OF SUBJECT MATTER |
| --- | --- |

G02B27/00(2006.01)i; F21S41/25(2018.01)i; F21S41/32(2018.01)i; F21S43/20(2018.01)i; F21S43/31(2018.01)i; F21W107/10(2018.01)n

According to International Patent Classification (IPC) or to both national classification and IPC

| B. | FIELDS SEARCHED |
| --- | --- |

Minimum documentation searched (classification system followed by classification symbols)

IPC:G02B27+; F21S+; F21W+

Documentation searched other than minimum documentation to the extent that such documents are included in the fields searched

Electronic data base consulted during the international search (name of data base and, where practicable, search terms used)

CNTXT, DWPI, ENTXT, ENTXTC, VEN, WPABS: 出光, 出光面, 出射, 入射, 入光, 反射, 折射, 控制点, 关键点, 逆, 微分, 向量, 矢量, emergent+, outgoing, emit+, incident, reflect+, refract+, control+ point, key point, inverse, differential, vector

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 116880060 A (CHANGZHOU XINGYU AUTOMOTIVE LIGHTING SYSTEMS CO., LTD.) 13 October 2023 (2023-10-13)<br>claims 1-10 | 1-10 |
| A | 李梦娇 (LI, Mengjiao). "B样条曲面重建关键技术的研究与实现 (Non-official translation: Research and Implementation of Key Technology in B-Spline Surface Reconstruction)" 沈阳师范大学硕士毕业论文 (Non-official translation: Master's Thesis, Shenyang Normal University), 01 March 2016 (2016-03-01),<br>text, pages 5-20 | 1-10 |
| A | JP H0798773 A (RICOH K. K.) 11 April 1995 (1995-04-11)<br>entire document | 1-10 |
| A | CN 110211201 A (BEIHANG UNIVERSITY) 06 September 2019 (2019-09-06)<br>entire document | 1-10 |
| A | CN 101908235 A (SUZHOU UNIVERSITY OF SCIENCE AND TECHNOLOGY) 08 December 2010 (2010-12-08)<br>entire document | 1-10 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **10 June 2024** | **13 June 2024** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**EP 4 538 769 A1**

**INTERNATIONAL SEARCH REPORT**

| International application No. |
|---|
| **PCT/CN2024/078878** |

**C.      DOCUMENTS CONSIDERED TO BE RELEVANT**

| Category* | Citation of document, with indication, where appropriate, of the relevant passages | Relevant to claim No. |
|---|---|---|
| A | US 2007229544 A1 (CHUNG-ANG UNIVERSITY INDUSTRY-ACADEMY COOPERATION FOUNDATION) 04 October 2007 (2007-10-04)<br>entire document | 1-10 |

INTERNATIONAL SEARCH REPORT
Information on patent family members

International application No.

**PCT/CN2024/078878**

| Patent document cited in search report | | | Publication date (day/month/year) | Patent family member(s) | | | Publication date (day/month/year) |
|---|---|---|---|---|---|---|---|
| CN | 116880060 | A | 13 October 2023 | None | | | |
| JP | H0798773 | A | 11 April 1995 | JP | 3148792 | B2 | 26 March 2001 |
| CN | 110211201 | A | 06 September 2019 | None | | | |
| CN | 101908235 | A | 08 December 2010 | None | | | |
| US | 2007229544 | A1 | 04 October 2007 | US | 7643026 | B2 | 05 January 2010 |
| | | | | KR | 100707841 | B1 | 17 April 2007 |

Form PCT/ISA/210 (patent family annex) (July 2022)

26

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 109116555 B